# EUROPEAN PATENT APPLICATION

(11) **EP 3 883 074 A1**
(43) Date of publication of application: **22.09.2021**
(21) Application number: 20163510.9
(22) Date of filing: 17.03.2020
(51) Int. Cl.: H02B 11/04, H02B 11/12

(54) **AN ELECTRIC SWITCHGEAR FOR LV AND MV APPLICATIONS**

(71) Applicant: ABB Schweiz AG, 5400 Baden (CH)
(72) Inventor: Peracchi, Fabrizio, 24021 Albino (BG) (IT); Arvati, Andrea, 24027 Nembro (BG) (IT)
(74) Representative: Zanoli, Enrico

(57) **Abstract**

An electric switchgear (1) for low-voltage or medium-voltage applications comprising a cabinet (2), a withdrawable switching apparatus (4) and a shutter assembly (5) movable along a reference plane of motion.

The electric switchgear comprises one or more power connection blocks (7, 8) comprising a line contact (70, 80), a disconnection contact (71, 81) and an insulating casing (72, 82).

According to the invention, at least said line contact and said insulating casing form a monolithic structure.

## Description

The present invention relates to an electric switchgear for low-voltage or medium-voltage applications.

More particularly, the present invention relates to an electric switchgear including a withdrawable switching apparatus and having improved power connection blocks for electrical connection with the conductors of an electric line.

Electric switchgears are well known in electric power transmission and distribution grids. Known electric switchgears usually comprise a metallic cabinet internally divided into several compartments or cells accommodating various apparatuses and equipment.

In many applications, electric switchgears include a switching apparatus (e.g. a circuit breaker) of the withdrawable type, i.e. reversibly movable between a first position (inserted position), in which the switching apparatus is electrically connected with the disconnection contacts of the switchgear, and a second position (withdrawn position), in which the switching apparatus is electrically disconnected from said disconnection contacts.

Generally, electric switchgears of the withdrawable type also include a shutter assembly to segregate live and power parts, in particular the disconnection contacts electrically connected with line conductors.

Even if they generally perform quite satisfactorily, currently available electric switchgears of the above-mentioned type still have some aspects that can be further improved.

As is known, these systems have a relatively huge size due to the need of ensuring suitable dielectric distances between the live parts and the remaining internal components.

Currently available electric switchgears have been experienced to provide poor performances in terms of dielectric insulation as soon as their overall size needs to be compacted for some reasons, e.g. due to the presence of relatively small installation spaces.

Thus, electric discharges or arcs may often occur at the live parts. These phenomena may cause relevant damages to the switchgear internal components and, possibly, be very dangerous for operators.

The main aim of the present invention is to provide an electric switchgear, in particular of the type including a withdrawable switching apparatus, which makes it possible to overcome or mitigate the aforementioned problems of the known art.

In the context of this aim, an object of the present invention is to provide an electric switchgear, in which the formation of electric discharges or electric arcs is prevented or greatly reduced, even if the internal dielectric distances are relatively small.

Another object of the present invention is to provide an electric switchgear, which can be easily designed with an overall compact size without jeopardizing the dielectric insulation levels between the live parts and other internal components of the switchgear.

Yet another object of the present invention is to provide an electric switchgear easy to manufacture at industrial level, at competitive costs with similar installations of the state of the art.

This aim and these objects, together with other objects that will become evident from the following description and accompanying drawings, are achieved, according to the present invention, by an electric switchgear, according to claim 1 and the related dependent claims set out below.

In a general definition, the electric switchgear, according to the invention, comprises:
- a cabinet having a plurality of walls defining an internal volume;
- one or more first line contacts intended to be electrically connected with corresponding first conductors of an electric line and one or more second line contacts intended to be electrically connected with corresponding second conductors of an electric line;
- one or more first disconnection contacts electrically connected with said first line contacts and one or more second disconnection contacts electrically connected with said second line contacts;
- a withdrawable switching apparatus comprising one or more electric poles and one or more third disconnection contacts and one or more fourth disconnection contacts electrically connected to said electric poles, said switching apparatus being reversibly movable between an inserted position, in which said third disconnection contacts are coupled with said first disconnection contacts and said fourth disconnection contacts are coupled with said second disconnection contacts, and a withdrawn position, in which said third disconnection contacts are decoupled from said first disconnection contacts and said fourth disconnection contacts are decoupled from said second disconnection contacts.

The electric switchgear, according to the invention, comprises one or more power connection blocks, each comprising a line contact, a disconnection contact and an insulating casing enclosing said line contact and said disconnection contact.

According to the invention, at least said line contact and said insulating casing form a monolithic structure.

Preferably, at least said line contact and said insulating casing are co-molded to form said monolithic structure.

According to an aspect of the invention, the switchgear comprises one or more first power connection blocks, each comprising a first line contact, a first disconnection contact and a first insulating casing enclosing said first line contact and said first disconnection contact. At least said first line contact and said first insulating casing form a monolithic structure.

Preferably, at least said first line contact and said first insulating casing are co-molded to form said monolithic structure.

Preferably, each first line contact is formed by an elongated shaped conductor having opposite first and second ends. Said first end is intended to be coupled with a corresponding first line conductor whereas said second end is coupled with a corresponding first disconnection contact.

Preferably, when it includes a plurality of electric phases, the switchgear, according to the invention, comprises a plurality of first line contacts formed by elongated shaped conductors having different lengths.

According to an aspect of the invention, the insulating casing of a power connection block comprises:
- a first main section defining a first chamber accommodating said first disconnection contact and being intended to receive a third disconnection contact of said switching apparatus, when said switching apparatus is in said inserted position;
- a first bushing section protruding from said first main section and surrounding said first line contact.

Preferably, the first main section of said first insulating casing comprises a first protrusion comprising one or more first coupling surfaces for mechanical connection with a support of said cabinet.

Preferably, the main section of said insulating casing comprises a first flange having one or more second coupling surfaces for mechanical connection with a support of said cabinet. Preferably, said first flange comprises also one or more third coupling surfaces for mechanical connection with corresponding coupling surfaces of the first insulating casing of an adjacent first power connection block.

Preferably, the first bushing section of said first insulating casing comprises an elongated portion protruding from said first main section and a transversal portion in distal position with respect to said first main section. Said transversal portion has a free end, at which said first line contact is intended to be coupled with a corresponding first line conductor.

Preferably, the first bushing section of said first insulating comprises a second protrusion comprising one or more fourth coupling surfaces for mechanical connection with a support of said cabinet.

According to an aspect of the invention, each first power connection block comprises one or more first test contacts enclosed in said first insulating casing. Each first test contact is electrically connected with a corresponding first line contact through a corresponding first capacitive electric circuit.

Preferably, said first test contact and said first capacitive electric circuit are incorporated in the first bushing section of said first insulating casing.

According to an aspect of the invention, the switchgear comprises one or more second power connection blocks, each comprising a second line contact, a second disconnection contact and a second insulating casing enclosing said second line contact and said second disconnection contact, at least said second line contact and said second insulating casing forming a monolithic structure.

Preferably, at least said second line contact and said second insulating casing are co-molded to form said monolithic structure.

Preferably, each second line contact is formed by an elongated shaped conductor having opposite third and fourth ends. Said third end is intended to be coupled with a corresponding second line conductor. Said fourth end is coupled with a corresponding second disconnection contact.

Preferably, the second insulating casing of a second power connection block comprises:
- a second main section defining a second chamber accommodating said second disconnection contact and being intended to receive a fourth disconnection contact of said switching apparatus, when said switching apparatus is in said inserted position;
- a second bushing section protruding from said second main section and surrounding said second line contact.

Preferably, the second main section of said second insulating casing comprises a third protrusion comprising one or more fifth coupling surfaces with a support of said cabinet. Preferably, the second main section of said second insulating casing comprises a second flange comprising one or more sixth coupling surfaces with a support of said cabinet. Preferably, said second flange comprises one or more seventh coupling surfaces with corresponding coupling surfaces of the second insulating casing of an adjacent second power connection block.

Preferably, the second bushing section of said second insulating casing has a free end, at which said second line contact is intended to be coupled with a corresponding second line conductor.

Further characteristics and advantages of the invention will emerge from the description of preferred, but not exclusive embodiments of a shutter device according to the present disclosure, non-limiting examples of which are provided in the attached drawings, wherein:
- figures 1-2 schematically show the switchgear, according to the invention, in different operating conditions;

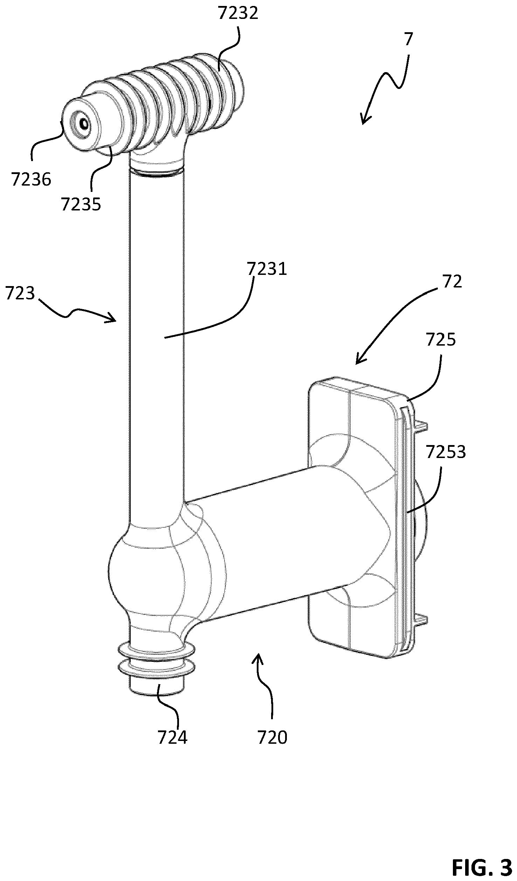

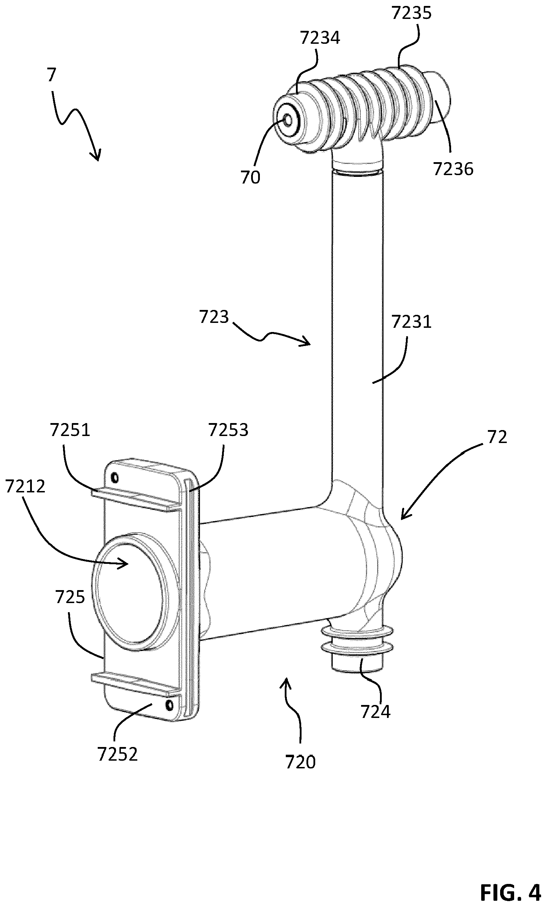

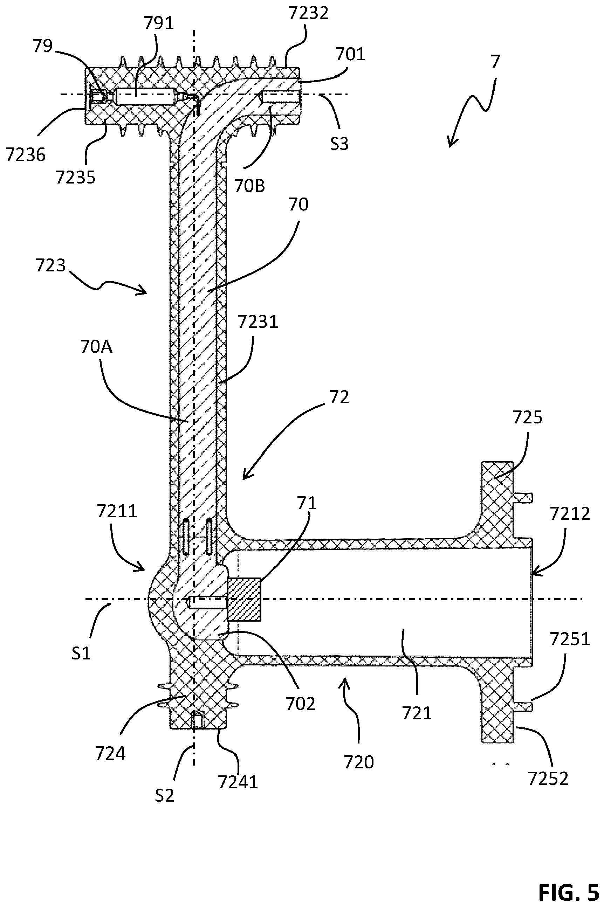

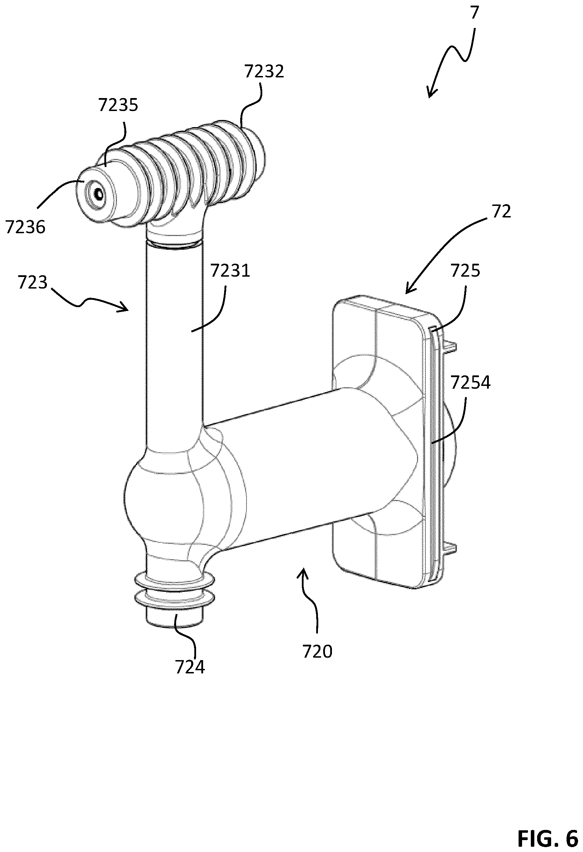

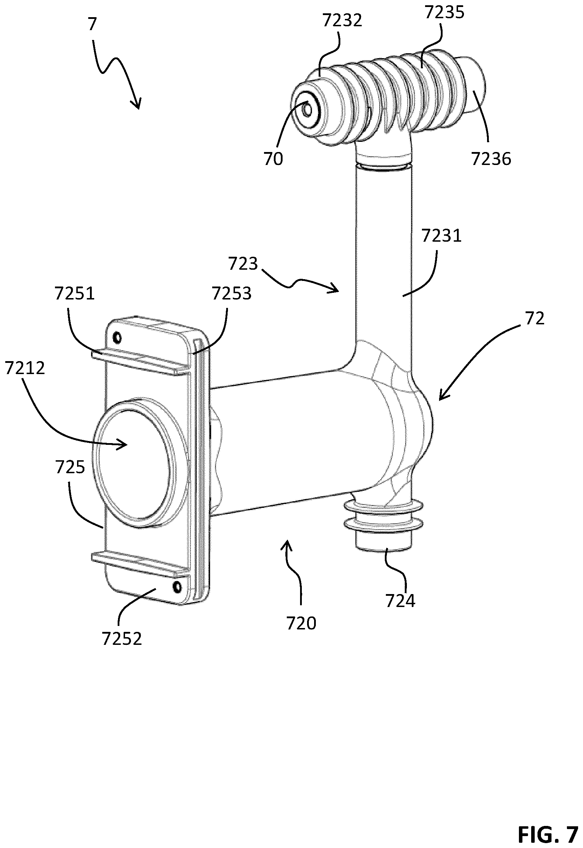

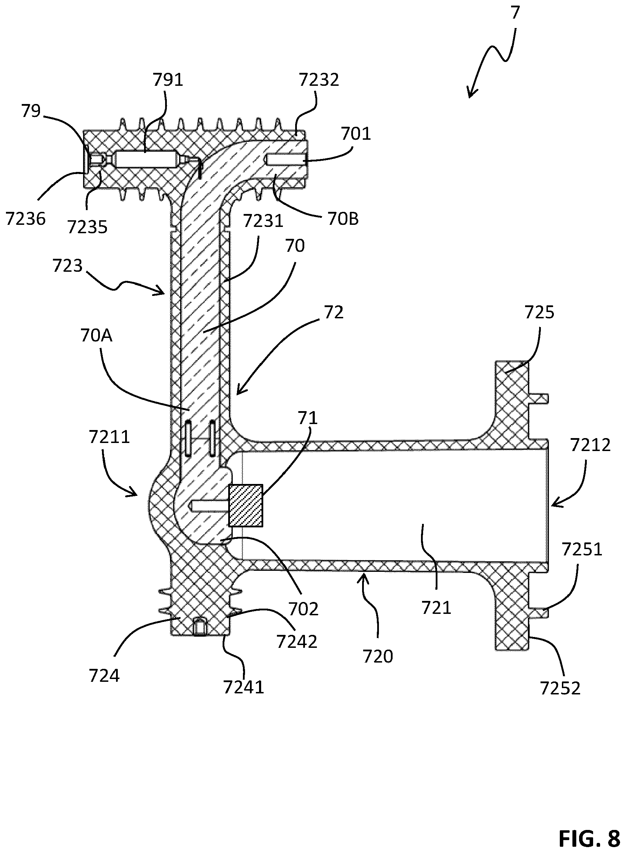

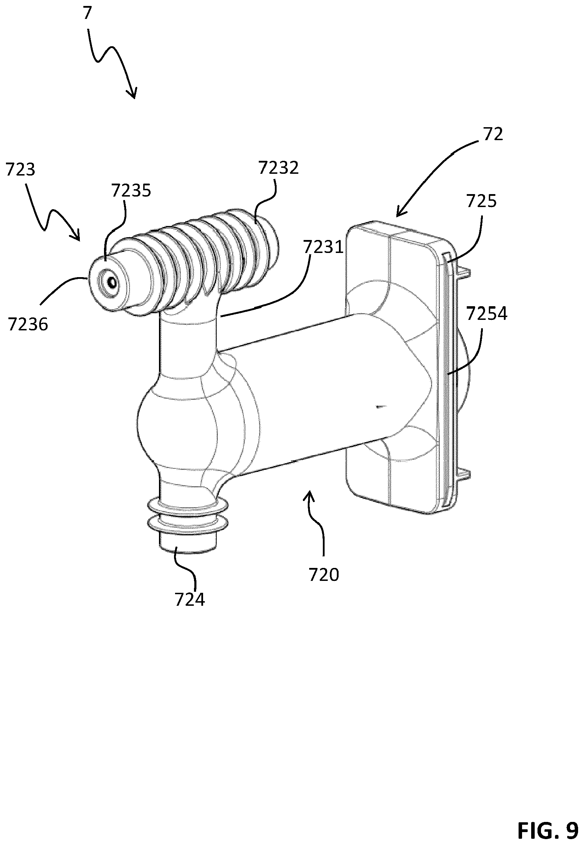

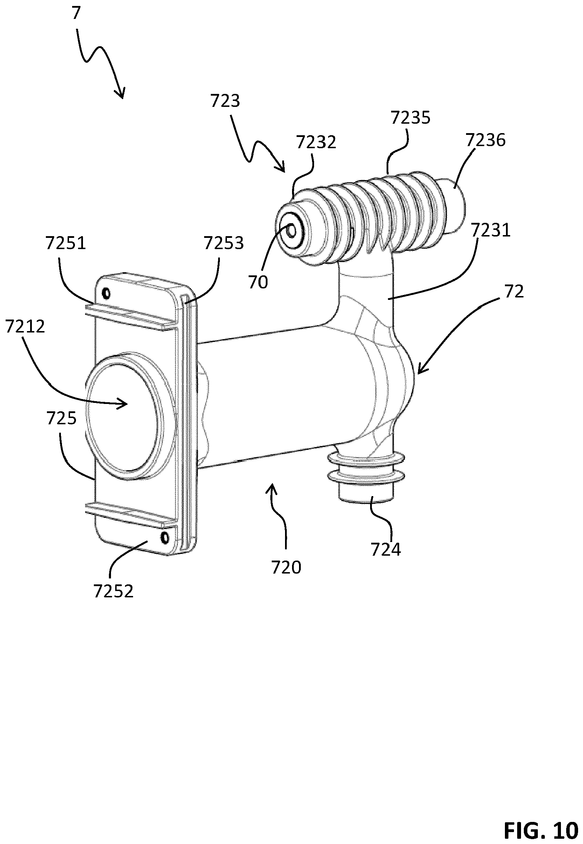

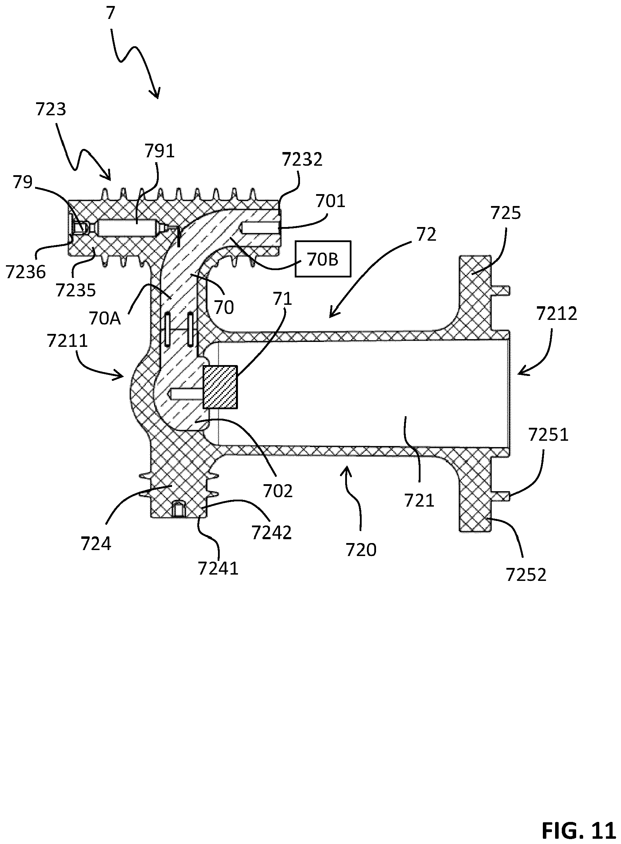

- figures 3-11 schematically show different kinds of a first power connection block included in the switchgear, according to the invention;

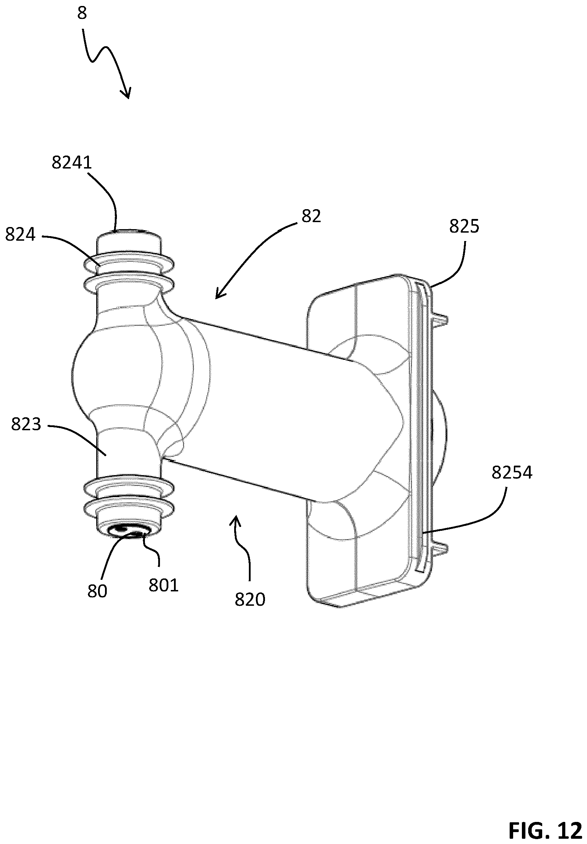

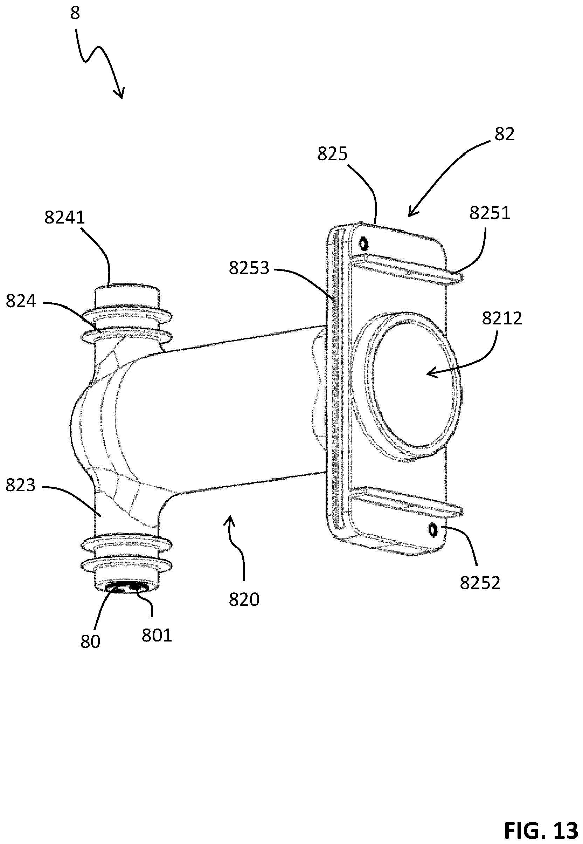

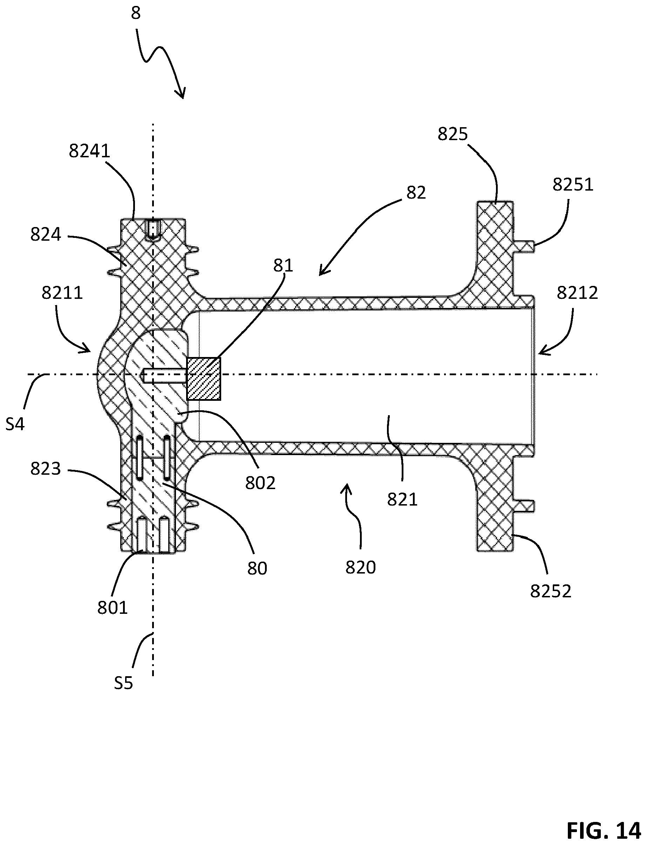

- figures 12-14 schematically show a second power connection block included in the switchgear, according to the invention.

Referring to the above-mentioned figures, the present invention relates to an electric switchgear 1 for low-voltage or medium-voltage applications.

For the purposes of the present invention, the term "low voltage" (LV) relates to operating voltages lower than 1 kV AC and 1.5 kV DC whereas the term "medium voltage" (MV) relates to operating voltages higher than 1 kV up to some tens of kV, e.g. 70 kV AC and 100 kV DC.

The switchgear 1 comprises a cabinet 2 including a plurality of walls 21, 22, 23, 24, 25 defining an internal volume.

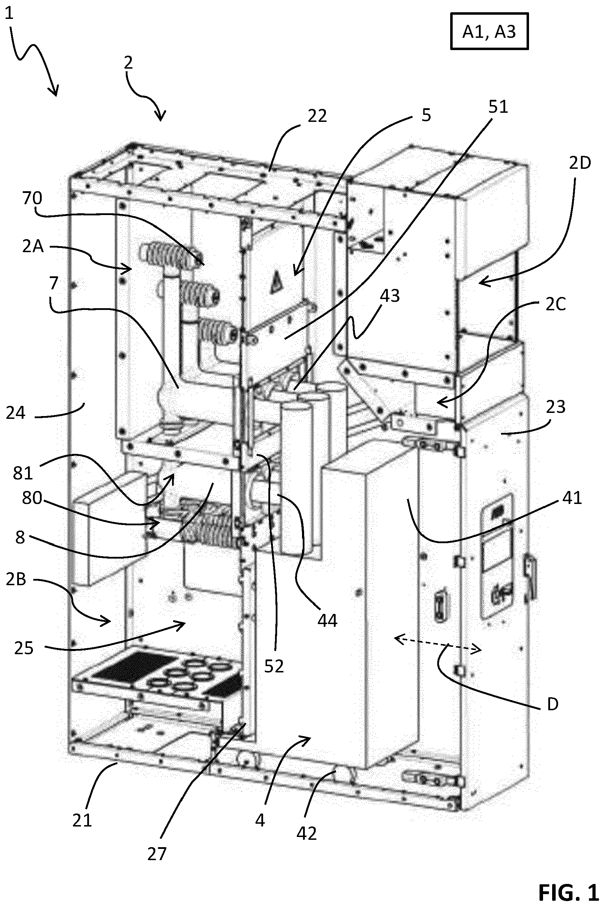

Referring to a normal installation position, the cabinet 2 comprises a horizontal basement wall 21, a horizontal top wall 22 in an opposite position with respect to the basement wall 21 and multiple vertical walls arranged perpendicularly with respect to the basement wall 21 (figures 1-2).

These vertical walls comprise a front wall 23, at which an operator can access to the internal volume of the cabinet, a rear wall 24 in opposite position with respect to the front wall 23 and a pair of opposite lateral walls 25 (partially shown in figures 1-2) perpendicular to the walls 21, 22, 23, 24.

In general, the cabinet 2 comprises a plurality of compartments 2A, 2B, 2C, 2D that are adjacent one to another to segregate different internal components of the switchgear.

Some compartments of the cabinet 2 are intended not to be accessible to a user during the operating life of the switchgear.

Referring to the embodiment shown in figures 1-2, these inaccessible compartments include, for example, a first compartment 2A to accommodate some live parts of the switchgear 1, i.e. the main electrical connections (e.g. bus-bars, cables, power connection blocks and disconnection contacts) with suitable conductors of an electric line, and a second compartment 2B to accommodate other live parts of the switchgear 1 and other power switching devices (not shown), such as an earthing apparatus, e.g. a disconnector.

Conveniently, the above-mentioned inaccessible compartments 2A, 2B are arranged in a distal position with respect to the front wall 23 of the cabinet 2.

Other compartments of the cabinet 2 are instead intended to be somehow accessible to a user during the operating life of the switchgear.

Referring to the embodiment shown in figures 1-2, these accessible compartments include, for example, a third compartment 2C to accommodate a switching apparatus (e.g. a withdrawable circuit breaker), and a fourth compartment 2D to accommodate accessory electrical connections and other accessory devices.

In general, the compartment 2C may be accessed by an operator only when the above-mentioned switching apparatus is not fed, i.e. it is disconnected from the live parts of the switchgear. The compartment 2D may instead be accessed even during service operation of the switching apparatus.

Conveniently, the above-mentioned accessible compartments 2C, 2D are arranged in a distal position with respect to the front wall 23 of the cabinet 2.

Advantageously, each compartment 2A, 2B, 2C, 2D of the cabinet 2 may, in turn, be divided in different partitions or cells to ensure a suitable segregation the internal components of the switchgear.

Preferably, the cabinet 2 conveniently comprises an internal wall 27 separating the inaccessible compartments 2A, 2B from the accessible compartment 2C.

The internal wall 27 is arranged perpendicularly with respect to the basement wall 21 and the lateral walls 25 of the cabinet 2. Referring to a normal installation position of the cabinet 2, the internal wall 27 extends vertically from the basement wall 21, in parallel with the front wall 23.

Conveniently, the internal wall 27 comprises a number of suitably arranged partitioning portions, each forming a physical barrier. However, the internal wall 27 includes one or more openings forming suitable passages between the inaccessible compartments 2A, 2B and the accessible compartment 2C of the cabinet 2 (figures 1-2).

In general, the cabinet 2 may be arranged according to solutions of known type. Thus, hereinafter, it will be not described in further details, for the sake of brevity.

The electric switchgear 1 comprises one or more first fixed line contacts 70 intended to be electrically connected with corresponding first conductors of an electric line (not shown), which are preferably electrically connected to an electric power source.

The electric switchgear 1 comprises one or more second fixed line contacts 80 intended to be electrically connected with corresponding second conductors of an electric line (not shown), which are preferably electrically connected to one or more electric loads.

The electric switchgear 1 comprises one or more first fixed disconnection contacts 71 electrically connected with the first line contacts 70 and one or more second fixed disconnection contacts 81 electrically connected with the second line contacts 80.

The electric switchgear 1 comprises one or more first power connection blocks 7 that are preferably accommodated in the compartment 2A of the cabinet.

A first power connection block 7 conveniently includes a corresponding first line contact 70 and a corresponding first disconnection contact 71, thereby providing for electrical connection with a corresponding first conductor of an electric line.

The electric switchgear 1 comprises one or more second power connection blocks 8 that are preferably accommodated in the compartment 2B of the cabinet.

A second power connection block 8 conveniently includes a corresponding second line contact 80 and a corresponding second disconnection contact 81, thereby providing for electrical connection with a corresponding second conductor of an electric line.

Referring to a normal installation position of the cabinet, the power connection blocks 7 are preferably arranged in an upper position, i.e. in a distal position with respect to the basement wall 21, while the power connection blocks 8 are preferably arranged in a lower position, i.e. in a proximal position with respect to the basement wall 21.

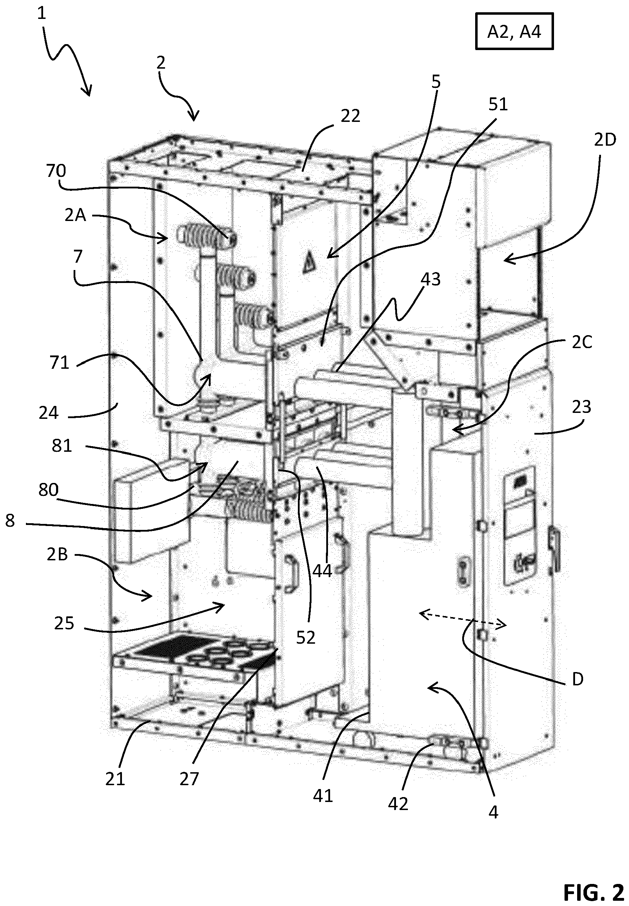

In the embodiment illustrated in figures 1 and 2, the switchgear 1 is of three-phase type. In this case, it conveniently includes three first power connection blocks 7 and three second power connection blocks 8.

According to other embodiments of the invention, however, the switchgear 1 may include a different number of electric phases and therefore a different number of power connection blocks, namely a first power connection block 7 and a second power connection block 8 for each electric phase.

The electric switchgear 1 comprises a withdrawable switching apparatus 4 accommodated in the compartment 2C of the cabinet 2.

The switching apparatus 4 preferably comprises a switching unit 41 mounted on a suitable track 42 that can slide along a suitable sliding plane parallel to the basement wall 21 of the cabinet 2.

The switching apparatus 4 is reversibly movable along a reference direction D, which is conveniently parallel to the basement wall 21 and perpendicular to the front wall 23 and the internal wall 27 of the cabinet 2 (figure 1).

The switching apparatus 4 comprises one or more third disconnection contacts 43, each electrically connected with a corresponding electric pole of the switching unit 41.

The third disconnection contacts 43 can be electrically coupled with or decoupled from the first disconnection contacts 71 of the switchgear upon a corresponding movement of the switching apparatus.

The switching apparatus 4 comprises one or more fourth disconnection contacts 44, each electrically connected with a corresponding electric pole of the switching unit 41.

The fourth disconnection contacts 44 can be electrically coupled with or decoupled from the second disconnection contacts 81 of the switchgear upon a corresponding movement of the switching apparatus.

Referring to a normal installation position of the cabinet, the disconnection contacts 43 are preferably arranged in an upper position, i.e. in a distal position with respect to the basement wall 21, while the disconnection contacts 44 are preferably arranged in a lower position, i.e. in a proximal position with respect to the basement wall 21.

As mentioned above, the disconnection contacts 43, 44 of the switching apparatus may be coupled or uncoupled with the disconnection contacts 71, 81 of the power connection blocks 7, 8 upon suitable movements of said switching apparatus.

In particular, the switching apparatus 4 is reversibly movable along the reference direction D of motion between:
- an inserted position A1 (figure 1), in which the third disconnection contacts 43 are coupled with the first disconnection contacts 71 and the fourth disconnection contacts 44 are coupled with the second disconnection contacts 81; and
- a withdrawn position A2 (figure 2), in which the third disconnection contacts 43 are decoupled from the first disconnection contacts 71 and the fourth disconnection contacts 44 are decoupled from the second disconnection contacts 81.

When the switching apparatus is in the inserted position A1, for each electric phase, a current can flow along a conductive path including a first line contact 70, a first disconnection contact 71, a third disconnection contact 43, an electric pole of the switching unit 41, a fourth disconnection contact 44, a second disconnection contact 81 and a second line contact 80.

When the switching apparatus is in the withdrawn position A2, the disconnection contacts 43, 44 are separated from the disconnections contacts 71, 81 and no currents can flow along the electric poles of said switching apparatus. The electrical continuity between the first and second line contacts 70, 80 of the switchgear (and therefore between the first and second conductors of the electric line) is therefore interrupted.

In order to couple with or decouple from the disconnector contacts 71 and 81, the disconnection contacts 43, 44 conveniently pass through suitable openings of the internal wall 27 of the cabinet.

In the embodiment illustrated in figures 1 and 2, the switching apparatus 4 is of three-phase type and it therefore includes three disconnection contacts 43 and three disconnection contacts 44.

According to other embodiments of the invention, however, the switching apparatus 4 may include a different number of disconnection contacts 43, 44 (namely, a disconnection contact 43 and a disconnection contact 44 for each electric phase).

Preferably, the switching apparatus 4 is a circuit breaker.

According to some embodiments of the invention, however, it may be of different type, e.g. contactor.

In general, the switching apparatus 4 may be arranged according to solutions of known type. Thus, hereinafter, it will be not described in further details, for the sake of brevity.

Preferably, the switchgear 1 comprises a shutter assembly 5.

The basic function of the shutter assembly 5 consists in providing a physical barrier between the disconnection contacts 71, 81 of the power connection blocks 7, 8 and the disconnection contacts 43, 44 of the switching apparatus at the above-mentioned openings of the internal wall 27, particularly when the switching apparatus is in a withdrawn position A2.

The shutter assembly 5 is operatively associated to the internal wall 27 of the cabinet 2 in such a way to be movable along a reference plane of motion defined by said internal wall. Preferably, the shutter assembly 5 comprises one or more shutter panels 51, 52 formed by plates of electrically conductive material arranged along the internal wall 27.

In figures 1-2, there is shown a shutter assembly 5 including two distinct shutter panels 51, 52 solidly connected one to another by suitable rods in such a way to move as one piece.

Other solutions are however possible, according to the needs. For example, the shutter assembly 5 may comprises multiple shutter panels moving independently one from another or a single shutter panel.

Conveniently, the shutter assembly 5 is reversibly movable along the reference plane of motion between:
- a non-protective position A3, in which the one or more shutter panels 51, 52 are not interposed between the first disconnection contacts 71 and the third disconnection contacts 43 and between the second disconnection contacts 81 and the second disconnection contacts 44, at the above-mentioned openings of the internal wall 27 (figure 1); and
- a protective position A4, in which the one or more shutter panels 51, 52 are interposed between the first disconnection contacts 71 and the third disconnection contacts 43 and between the second disconnection contacts 81 and the fourth disconnection contacts 44, at the above-mentioned openings of the internal wall 27 (figure 2).

Preferably, the electric switchgear 1 comprises an actuation mechanism (not shown) including a plurality of motion transmission levers mechanically connecting the switching apparatus 4 (in particular the movable truck 42) with the shutter assembly 5.

Said actuation mechanism is basically directed to actuate the shutter assembly 5 in coordination with the motion of the switching apparatus 4.

In general, the shutter assembly 5 and the above-mentioned actuation mechanism may be arranged according to solutions of known type. Thus, hereinafter, they will be not described in further details, for the sake of brevity.

According to an important aspect of the invention, one or more power connection blocks 7, 8 are arranged in such a way to ensure a suitable dielectric insulation of the live parts of the switchgear and, at the same time, in such a way to have a reduced size with respect to corresponding solutions of the state of the art.

In particular, one or more power connection blocks 7, 8 comprise a line contact 70, 80, a disconnection contact 71, 81 and an insulating casing 72, 82 of electrically insulating material, which encloses said line contact and said disconnection contact.

According to the invention, at least the line contact 70, 80 and the insulating casing 72, 82 form a monolithic structure.

For the sake of clarity, it is specified that the term "monolithic structure" identifies a structure made in a single piece, i.e. without using specific connection means to join different parts or materials.

Preferably, at least the line contact 70, 80 and the insulating casing 72, 82 are co-molded to form said monolithic structure.

The co-molding process adopted to obtain the above-mentioned monolithic structure may be of known type and it will here not be described in details for the sake of brevity.

The solution provided by the invention allows preventing the use of screws or other mechanical connection means to assembly a line contact 70, 80 with the corresponding insulating casing 72, 82 as it commonly occurs in the available solutions of the state of the art. The insulating casing 72, 82 of a power connection block 7, 8 has thus a single-piece structure made of electrically insulating material that does not show breaking lines or breaking points. As it easy to understand this feature greatly improves the electric insulation performances of the power connection blocks 7, 8.

Therefore, the power connection blocks 7, 8 can ensure satisfactory dielectric insulation levels of the corresponding fixed line contacts and fixed disconnection contacts while providing electrical continuity between the line conductors these latter fixed contacts of the switchgear. The above-mentioned improvements of the solution proposed by the invention allow designing switchgears with an overall compact size without jeopardizing the dielectric insulation levels between the live parts and other internal components.

According to preferred embodiments of the invention (figures 1-2):
- each first power connection block 7 comprises a first line contact 70, a first disconnection contact 71 and a first insulating casing 72 made of electrically insulating material, which encloses said first line contact and said first disconnection contact. Conveniently, at least the first line contact 70 and the first insulating casing 72 of each first power connection block 7 are co-molded to form a monolithic structure;
- each second power connection block 8 comprises a second line contact 80, a second disconnection contact 81 and a second insulating casing 82 made of electrically insulating material, which encloses said second line contact and said second disconnection contact. Conveniently, at least the second line contact 80 and the first insulating casing 82 of each second power connection block 8 are co-molded to form a monolithic structure.

For the sake of simplicity, the most relevant aspects of the invention will be described in the following referring to such preferred embodiments.

According to an aspect of the invention, the first line contact 70 of a first power connection block 7 is formed by an elongated shaped conductor having opposite first and second ends 701, 702.

The first end 701 of the line contact 70 is intended to be coupled (e.g. screwed) with a corresponding first line conductor while the second end 702 is coupled (e.g. screwed or made in one piece) with a corresponding first disconnection contact 71.

Preferably, when the power connection block 7 is installed in its natural operating position, the line contact 70 has a vertical elongated portion 70A extending along a direction substantially perpendicular to the basement wall 21 of the cabinet 2 towards the top wall 22 and it has a transversal portion 70B extending along a direction substantially parallel to the basement wall 21 of the cabinet 2 and oriented towards the front wall 23.

Preferably, the transversal portion 70B of the line contact 70 comprises the first end 701 intended to be coupled with a corresponding first line conductor whereas the vertical portion 70A of the line contact 70 comprises the second end 702 coupled with a corresponding first disconnection contact 71.

Preferably, the line contact 70 has a "reversed-L" shape with rounded edges, in which the longer leg is formed by the vertical portion 70A and the shorter leg is formed by the transversal portion 70B.

Preferably, when the electric switchgear comprises a plurality of electric phases, the first line contacts 70 are formed by elongated shaped conductors having different lengths.

In particular, the vertical portions 70A of the line contacts 71 have different lengths, which means that the second ends 701 of the line contacts 71 are at different heights with respect to the basement wall 21.

This solution allows saving space in the compartment 2A of the cabinet 2 and it simplifies the electrical connection with the first conductors of the electric line.

Preferably (as shown in the cited figures), the first disconnection contact 71 of a first power connection block 7 is formed by a conductive bush that is connected (e.g. screwed) on the second end 702 of the corresponding line contact 70, when the single piece structure formed by the line contact 70 and the insulating casing 72 is realized.

According to alternative embodiments, the disconnection contact 71 may be realized in one piece with the line contact 70. In this case, it will be part of the co-molded monolithic structure of the corresponding power connection block 7.

According to an aspect of the invention, the insulating casing 72 of a first power connection block 7 comprises a first main section 720 and a first bushing section 723.

The main section 720 of the insulating casing 72 is designed in such a way to include a first chamber 721 accommodating a terminal portion of the line contact 70 (including the second end 702) and the first disconnection contact 71.

The chamber 721 receives a third disconnection contact 43 of the switching apparatus 4, when said switching apparatus is in the inserted position A1.

Preferably, the chamber 721 has an elongated shape extending along a first axis S1 parallel to the direction D of motion of the switching apparatus and having opposite ends 7211 and 7212. In particular, the chamber 721 includes a first blind end 7211, at which a terminal portion of the line contact 70 (including the second end 702) and the first disconnection contact 71 are accommodated, and a first open end 7212 that allows the passage of a third disconnection contact 43 of the switching device 4.

Preferably, the main section 720 of the insulating casing 72 comprises a first protrusion 724 for mechanically connecting of the first power connection block 7 to a fixed support. Preferably, the protrusion 724 comprises one or more first coupling surfaces 7241 for mechanical connection with a support of the cabinet 2.

Preferably, the protrusion 724 comprises a free end comprising a coupling surface 7241, at which it is mechanically coupled (e.g. screwed) with an internal supporting wall or element of the cabinet 2

Preferably, the protrusion 724 is formed by a solid elongated portion of the first insulating casing 72, which conveniently has a cylindrical shape and it is externally provided with external insulating fins.

Preferably, the protrusion 724 is positioned at the blind end 7211 of the above-mentioned chamber 721 and it protrudes from an opposite side of the main section 720 with respect to the bushing section 723 of the insulating casing 72.

Preferably, when the power connection block 7 is installed in its operating position, the protrusion 724 extends along a direction substantially perpendicular to the basement wall 21 of the cabinet 2 towards said basement wall.

Preferably, the main section 720 of the insulating casing 72 comprises a first flange 725 for mechanically connecting of the first power connection block 7 to a fixed support.

Preferably, the flange 725 comprises one or more second coupling surfaces 7251, 7252 for mechanical connection with a support of the cabinet 2.

Preferably, the flange 725 comprises one or more third coupling surfaces 7253, 7254 for mechanical connection with corresponding coupling surfaces of the first insulating casing 72 of another first power connection block 7.

Preferably, the flange 725 is positioned at the open end 7212 of the above-mentioned chamber 721.

Preferably, the flange 725 is formed by a shaped protrusion (e.g. rectangular or squared) of the insulating casing 72, which is oriented perpendicularly with respect to the extension axis S1 of the first chamber 721.

Preferably, at a side in distal position with respect to the blind end 7212 of the above-mentioned chamber 721, the flange 725 comprises flat edge portions 7252, at which it may be mechanically connected (e.g. screwed) with an internal supporting wall of the cabinet 2. Preferably, at the same side, the flange 725 comprises one or more protruding ribs 7251 intended to be inserted into suitable openings of the above-mentioned internal supporting wall of the cabinet 2.

Preferably, the flange 725 comprises opposite first and second lateral edges that are oriented perpendicularly with respect to the basement wall 21 of the cabinet 2, when the power connection block 7 is installed in its operating position,

At the above-mentioned first lateral edge, the flange 725 comprises a coupling groove 7253 while, at the above-mentioned second lateral edge, it comprises a coupling rib 7254.

When the electric switchgear comprises a plurality of electric phases, the coupling groove 7253 and/or the coupling rib 7254 may be coupled with a corresponding coupling rib 7254 and/or coupling groove 7253 of the flange 725 of an adjacent power connection block 7.

This solution further improves the stability of first power connection blocks 7, it allows reducing the lateral space needed to accommodate the first power connection blocks 7 and it further improves the electrical insulation performances first power connection blocks 7, as the insulating casings 72 of adjacent power connection blocks 7 may be mechanically combined to form a single insulating structure.

The bushing section 723 of the insulating casing 72 is designed in such a way to protrude from the main section 720 and surround the line contact 70 for the entire remaining length of this latter.

Preferably, the bushing section 723 comprises a free end, at which the line contact 70 is intended to be coupled with a corresponding first line conductor.

Preferably, the bushing section 723 comprises a vertical portion 7231 protruding from the first main section 720 at the blind end 7211 of the chamber 721 on an opposite side with respect to the protrusion 724 of the main section 720.

The vertical portion 7231 of the bushing section 723 extends along a second axis along S2 perpendicular to a basement wall 21 of the cabinet 2 and it is oriented towards the top wall 22, when the power connection block 7 is installed in its operating position.

The vertical portion 7231 of the bushing section 723 has preferably a cylindrical shape and it is provided with external insulating fins.

Preferably, the bushing section 723 of the insulating casing 72 comprises a transversal portion 7232 in distal position with respect to the main section 720 and extending along a direction substantially parallel to the basement wall 21 of the cabinet 2 and oriented towards the front wall 23.

Conveniently, the transversal portion 7232 includes the free end of this latter.

The transversal portion 7232 has preferably a cylindrical shape and it is provided with external insulating fins.

Preferably, the bushing section 723 of the insulating casing 72 comprises a second protrusion 7235 for mechanically connecting of the first power connection block 7 to a fixed support. Preferably, the protrusion 7235 comprises one or more fourth coupling surfaces 7236 for mechanical connection with a support of the cabinet 2.

Preferably, the protrusion 7235 comprises a free end comprising a coupling surface 7236, at which it is mechanically coupled (e.g. screwed) with an internal supporting wall or element of the cabinet 2

Preferably, the protrusion 7235 is formed by a solid elongated portion of the bushing section 723, which conveniently has a cylindrical shape and it is externally provided with external insulating fins.

Preferably, the protrusion 7235 is aligned with the transversal portion 7232 of the bushing section 723 on an opposite side of this latter and oriented towards an opposite direction. Preferably, the bushing section 723 has a "T-shape", in which the longer leg is formed by the vertical portion 7231 and the shorter legs are formed by the transversal portion 7232 and the protrusion 7235.

According to an aspect of the invention, a first power connection block 7 comprises one or more first test contacts 79 to allow a measurement of the electric voltage of the line contacts 70.

A test contact 79 is electrically connected with a corresponding line contact 70 through a corresponding first capacitive electric circuit 791 (which may be of known type).

Preferably, the test contact 79 and the capacitive electric circuit 791 are incorporated in the bushing section 723 of the insulating casing 72, in particular at the fixing portion 7235 of this latter, in such a way to be fully surrounded by electrically insulating material.

According to an aspect of the invention, the second line contact 80 of a second power connection block 8 is formed by an elongated shaped conductor having opposite first and second ends 801, 802.

The first end 801 of the line contact 80 is intended to be coupled (e.g. screwed) with a corresponding second line conductor while the second end 802 is coupled (e.g. screwed or made in one piece) with a corresponding second disconnection contact 81.

Preferably, when the power connection block 8 is installed in its natural operating position, the line contact 80 extends along a direction substantially perpendicular to the basement wall 21 of the cabinet 2 towards said basement wall.

Preferably, the line contact 80 has a cylindrical shape with rounded edges.

Preferably (as shown in the cited figures), the second disconnection contact 81 of a second power connection block 8 is formed by a conductive bush that is connected (e.g. screwed) on the second end 802 of the corresponding line contact 80, when the single piece structure formed by the line contact 80 and the insulating casing 82 is realized.

According to alternative embodiments, the disconnection contact 81 may be realized in one piece with the line contact 80. In this case, it will be part of the co-molded monolithic structure of the corresponding power connection block 8.

According to an aspect of the invention, the insulating casing 82 of a second power connection block 8 comprises a second main section 820 and a second bushing section 823. The main section 820 of the insulating casing 82 is designed in such a way to include a second chamber 821 accommodating a terminal portion of the line contact 80 (including the second end 802) and the second disconnection contact 81.

The chamber 821 receives a fourth disconnection contact 44 of the switching apparatus 4, when said switching apparatus is in the inserted position A1.

Preferably, the chamber 821 has an elongated shape extending along a fourth axis S4 parallel to the direction D of motion of the switching apparatus and having opposite ends 8211 and 8212.

In particular, the chamber 821 includes a second blind end 8211, at which a terminal portion of the line contact 80 (including the second end 802) and the first disconnection contact 81 are accommodated, and a first open end 8212 that allows the passage of a fourth disconnection contact 44 of the switching device 4.

Preferably, the main section 820 of the insulating casing 82 comprises a third protrusion 824 for mechanically connecting of the first power connection block 8 to a fixed support. Preferably, the protrusion 824 comprises one or more fifth coupling surfaces 8241 for mechanical connection with a support of the cabinet 2.

Preferably, the protrusion 824 comprises a free end comprising a coupling surface 8241, at which it is mechanically coupled (e.g. screwed) with an internal supporting wall or element of the cabinet 2

Preferably, the protrusion 824 is formed by a solid elongated portion of the second insulating casing 82, which conveniently has a cylindrical shape and it is externally provided with external insulating fins.

Preferably, the protrusion 824 is positioned at the blind end 8211 of the above-mentioned chamber 821 and it protrudes from an opposite side of the main section 820 with respect to the busing section 823 of the insulating casing 82.

Preferably, when the power connection block 8 is installed in its operating position, the protrusion 824 extends along a direction substantially perpendicular to the basement wall 21 of the cabinet 2 towards the top wall 22.

Preferably, the main section 820 of the insulating casing 82 comprises a second flange 825 for mechanically connecting of the second power connection block 8 to a fixed support. Preferably, the flange 825 comprises one or more sixth coupling surfaces 8251, 8252 for mechanical connection with a support of the cabinet 2.

Preferably, the flange 825 comprises one or more seventh coupling surfaces 8253, 8254 for mechanical connection with corresponding coupling surfaces of the insulating casing 82 of another second power connection block 8.

Preferably, the flange 825 is positioned at the open end 8212 of the above-mentioned chamber 821.

Preferably, the flange 825 is formed by a shaped protrusion (e.g. rectangular or squared) of the insulating casing 82, which is oriented perpendicularly with respect to the extension axis S4 of the first chamber 821.

Preferably, at a side in distal position with respect to the blind end 8212 of the above-mentioned chamber 821, the flange 825 comprises flat edge portions 8252, at which it may be mechanically connected (e.g. screwed) with an internal supporting wall of the cabinet 2. Preferably, at the same side, the flange 825 comprises one or more protruding ribs 8251 intended to be inserted into suitable openings of the above-mentioned internal supporting wall of the cabinet 2.

Preferably, the flange 825 comprises opposite third and fourth lateral edges that are oriented perpendicularly with respect to the basement wall 21 of the cabinet 2, when the power connection block 8 is installed in its operating position.

At the above-mentioned third lateral edge, the flange 825 comprises a coupling groove 8253 while, at the above-mentioned fourth lateral edge, it comprises a coupling rib 8254.

When the electric switchgear comprises a plurality of electric phases, the coupling groove 8253 and/or the coupling rib 8254 may be coupled with a corresponding coupling rib 8254 and/or coupling groove 8253 of the flange 825 of an adjacent power connection block 8.

This solution provides similar advantages to those described for the flanges of the first power connection blocks 7.

The bushing section 823 of the insulating casing 82 is designed in such a way to protrude from the main section 820 and surround the line contact 80 for the entire remaining length of this latter.

Preferably, the bushing section 823 comprises a free end, at which the line contact 80 is intended to be coupled with a corresponding second line conductor.

The bushing section 823 has preferably a cylindrical shape and it is provided with external insulating fins.

According to some embodiments of the invention (not shown), a first power connection block 8 may comprise one or more second test contacts to allow a measurement of the electric voltage of the line contacts 80.

A second test contact is electrically connected with a corresponding line contact 80 through a corresponding second capacitive electric circuit 891 (which may be of known type). Preferably, the second test contact and the related second capacitive electric circuit are incorporated in the protrusion 824 of the insulating casing 82, in such a way to be fully surrounded by electrically insulating material.

As it is apparent, figures 1-2 refer to preferred embodiments of the invention, in which each first power connection block 7 and each second power connection block 8 includes a monolithic structure formed by at least by a co-molded a line contact 70, 80 and insulating casing 72, 82.

According to some embodiments of the invention (not shown), only some of the power connection blocks 7, 8 (for example only the first connection blocks 7 or only the second power connection blocks 8) may include a co-formed monolithic structure in accordance with the claimed invention.

It has been found in practice that the electric switchgear, according to the invention, provide relevant advantages with respect to corresponding solutions of the state of the art.

Due to the arrangement of power connection blocks 7, 8 having improved insulating performances the formation of electric discharges or electric arcs is prevented or greatly reduced, even if the internal dielectric distances are relatively small.

This allows carrying out withdrawing operations of the switching apparatus in a very safe manner and it greatly improves safety levels for operators possibly accessing the compartment 2C of the cabinet 2, e.g. during maintenance operations.

Moreover, the electric switchgear can be easily designed with an overall compact size without jeopardizing the dielectric insulation levels between the live parts and the other internal components.

The electric switchgear, according to the invention, can be easily realized at industrial levels. Thus, it can be easily manufactured at competitive costs with similar installations of the state of the art.

## Claims

1. An electric switchgear (1) for low-voltage or medium-voltage applications comprising:
- a cabinet (2) having a plurality of walls (21, 22, 23, 24, 25) defining an internal volume;
- one or more first line contacts (70) intended to be electrically connected with corresponding first conductors of an electric line and one or more second line contacts (80) intended to be electrically connected with corresponding second conductors of an electric line;
- one or more first disconnection contacts (71) electrically connected with said first line contacts (70) and one or more second disconnection contacts (81) electrically connected with said second line contacts (80);
- a withdrawable switching apparatus (4) comprising one or more third disconnection contacts (43) and one or more fourth disconnection contacts (44), said switching apparatus being reversibly movable between an inserted position (A1), in which said third disconnection contacts (43) are coupled with said first disconnection contacts (71) and said fourth disconnection contacts (44) are coupled with said second disconnection contacts (81), and a withdrawn position (A2), in which said third disconnection contacts (43) are decoupled from said first disconnection contacts (71) and said fourth disconnection contacts (44) are decoupled from said second disconnection contacts (81);
**characterised in that** it comprises one or more power connection blocks (7, 8) comprising a line contact (70, 80) of the switchgear, a disconnection contact (71, 81) of the switchgear and an insulating casing (72, 82) enclosing said line contact and said disconnection contact, wherein at least said line contact (70, 80) and said insulating casing (72, 82) form a monolithic structure.

2. Electric switchgear, according to claim 1, **characterised in that** at least said line contact (70, 80) and said insulating casing (72, 82) are co-molded to form said monolithic structure.

3. Electric switchgear, according to one of the previous claims, **characterised in that** it comprises one or more first power connection blocks (7) comprising a first line contact (70), a first disconnection contact (71) and a first insulating casing (72) enclosing said first line contact and said first disconnection contact, at least said first line contact (70) and said first insulating casing (72) forming a monolithic structure.

4. Electric switchgear, according to claim 3, **characterised in that** a first line contact (70) is formed by an elongated shaped conductor having opposite first and second ends (701, 702), said first end being intended to be coupled with a corresponding first line conductor, said second end being coupled with a corresponding first disconnection contact (71).

5. Electric switchgear, according to one of the claims from 3 to 4, **characterised in that** it comprises a plurality of first line contacts (70) formed by elongated shaped conductors having different lengths.

6. Electric switchgear, according to one of the claims from 3 to 5, **characterised in that** said first insulating casing (72) comprises:
- a first main section (720) defining a first chamber (721) accommodating said first disconnection contact (71) and being intended to receive a third disconnection contact (43) of said switching apparatus, when said switching apparatus is in said inserted position (A1);
- a first bushing section (723) protruding from said first main section (720) and surrounding said first line contact (70).

7. Electric switchgear, according to claim 6, **characterised in that** said first main section (720) comprises a first protrusion (724) comprising one or more first coupling surfaces (7241) for mechanical connection with a support of said cabinet.

8. Electric switchgear, according to one of the claims from 6 to 7, **characterised in that** said first main section (720) comprises a first flange (725) having one or more second coupling surfaces (7251, 7252) for mechanical connection with a support of said cabinet.

9. Electric switchgear, according to one claim 8, **characterised in that** said first flange (725) comprises one or more third coupling surfaces (7253, 7254) for mechanical connection with corresponding coupling surfaces of the first insulating casing (72) of an adjacent first power connection block (7).

10. Electric switchgear, according to one of the claims from 6 to 9, **characterised in that** said first bushing section (723) comprises an elongated portion (7231) protruding from said first main section (720) and a transversal portion (7232) in distal position with respect to said first main section (720), said transversal portion having a free end (7234), at which said first line contact (70) is intended to be coupled with a corresponding first line conductor.

11. Electric switchgear, according to one of the claims from 6 to 10, **characterised in that** said first bushing section (723) comprises a second protrusion (7235) comprising one or more fourth coupling surfaces (7236) for mechanical connection with a support of said cabinet.

12. Electric switchgear, according to one of the claims from 3 to 11, **characterised in that** a first power connection block (7) comprises one or more first test contacts (79), a first test contact being electrically connected with a corresponding first line contact (70) through a corresponding first capacitive electric circuit (791).

13. Electric switchgear, according to claims 11 and 12, said first test contact (79) and said first capacitive electric circuit (791) are incorporated in said first bushing section (723).

14. Electric switchgear, according to one or more of the previous claims, **characterised in that** it comprises one or more second power connection blocks (8) comprising a second line contact (80), a second disconnection contact (81) and a second insulating casing (82) enclosing said second line contact and said second disconnection contact, at least said second line contact (80) and said second insulating casing (82) forming a monolithic structure.

15. Electric switchgear, according to claim 14, **characterised in that** a second line contact (80) is formed by an elongated shaped conductor having opposite third and fourth ends (801, 802), said third end being intended to be coupled with a corresponding second line conductor, said fourth end being coupled with a corresponding second disconnection contact (81).

16. Electric switchgear, according to one of the claims from 14 to 15, **characterised in that** said second insulating casing (82) comprises:
- a second main section (820) defining a second chamber (821) accommodating said second disconnection contact (81) and being intended to receive a fourth disconnection contact (44) of said switching apparatus, when said switching apparatus is in said inserted position (A1);
- a second bushing section (823) protruding from said second main section (820) and surrounding said second line contact (80).

17. Electric switchgear, according to claim 16, **characterised in that** said second main section (820) comprises a third protrusion (824) comprising one or more fifth coupling surfaces (8241) with a support of said cabinet.

18. Electric switchgear, according to one of the claims from 16 to 17, **characterised in that** said second main section (820) comprises a second flange (825) comprising one or more sixth coupling surfaces (8251, 8252) with a support of said cabinet.

19. Electric switchgear, according to one claim 18, **characterised in that** said second flange (825) comprises one or more seventh coupling surfaces (8253, 8254) with corresponding coupling surfaces of the second insulating casing (82) of an adjacent second power connection block (8).

20. Electric switchgear, according to one of the claims from 16 to 19, **characterised in that** said second bushing section (823) has a free end (8231), at which said second line contact (80) is intended to be coupled with a corresponding second line conductor.
